# EUROPEAN PATENT SPECIFICATION

(11) **EP 3 007 187 B1**
(45) Date of publication and mention of the grant of the patent: **06.01.2021**
(21) Application number: 14803615.5
(22) Date of filing: 08.04.2014
(51) Int. Cl.: H01F 1/26, H01F 1/37, H05K 1/16, G06F 3/046, H05K 3/28, H01F 41/16

(54) **SOFT-MAGNETIC RESIN COMPOSITION, SOFT-MAGNETIC ADHESIVE FILM, CIRCUIT BOARD WITH SOFT-MAGNETIC FILM LAMINATED THERETO, AND POSITION DETECTION DEVICE**
WEICHMAGNETISCHE HARZZUSAMMENSETZUNG, WEICHMAGNETISCHEN KLEBEFILM, LEITERPLATTE MIT DARAUF LAMINIERTER WEICHMAGNETISCHER FOLIE UND POSITIONSBESTIMMUNGSVORRICHTUNG
COMPOSITION DE RÉSINE À AIMANTATION TEMPORAIRE, FILM ADHÉSIF À AIMANTATION TEMPORAIRE, CARTE DE CIRCUIT SUR LAQUELLE EST STRATIFIÉ LE FILM À AIMANTATION TEMPORAIRE ET DISPOSITIF DE DÉTECTION DE POSITION

(30) Priority: 27.05.2013 JP 2013110804; 22.08.2013 JP 2013172565
(43) Date of publication of application: 13.04.2016
(73) Proprietor: Nitto Denko Corporation, Ibaraki-shi, Osaka 567-8680 (JP)
(72) Inventor: HABU, Takashi, Ibaraki-shi, Osaka 567-8680 (JP); EBE, Hirofumi, Ibaraki-shi, Osaka 567-8680 (JP)
(74) Representative: Hoffmann Eitle
(86) International application number: PCT/JP2014/060220
(87) International publication number: WO 2014/192427

(56) References cited:
- EP-A1- 2 963 657
- EP-A1- 2 963 658
- WO-A1-2008/123362
- JP-A- S6 058 497
- JP-A- H10 289 815
- JP-A- 2006 202 266
- JP-A- 2007 031 695
- JP-A- 2007 258 432
- JP-A- 2008 134 837
- JP-A- 2009 059 752
- JP-A- 2009 059 753
- JP-A- 2009 218 450
- JP-A- 2010 196 123
- JP-A- 2012 212 790
- JP-A- 2013 062 318
- JP-A- 2013 062 318
- JP-B2- 4 807 523
- US-A- 5 714 238

## Description

The present invention relates to a soft magnetic resin composition, a soft magnetic adhesive film, a soft magnetic film laminate circuit board, and a position detection device.

### BACKGROUND ART

A position detection device having a pen-type position indicator for detecting a position by moving the pen on a position detection plane is called a digitizer, and is widely spread as an input device for computers. The position detection device includes a position detection flat plate, and a circuit board (sensor board) disposed therebelow and having loop coils formed on the surface of the board. Then, the position of the position indicator is detected by using electromagnetic induction generated by the position indicator and the loop coils.

The following Patent Document 1 has proposed, for example, a method in which a soft magnetic film containing a soft magnetic material is disposed at a face (opposite face) opposite to the face of the position detection plane of the sensor board in a position detection device for efficient communication by controlling the magnetic flux generated at the time of electromagnetic induction.

The following Patent Document 1 discloses a magnetic film containing a soft magnetic powder, a binder resin composed of, for example, acrylic rubber, phenol resin, epoxy resin, and melamine, and a metal salt of phosphinic acid. The following Patent Document 2 describes a conductive adhesive comprising 30-45% by volume of a Component (A) which can be a nickel or nickel-boron alloy and which can adhere a semiconductor element, chip parts or discrete parts to a printed wiring board without causing electromigration Patent Documents 3 and 4 describe resin compositions with more than 60% flat soft magnetic particles and phosphate ester as dispersant.

### Citation List

### Patent Document

Patent Document 1: Japanese Unexamined Patent Publication No. 2012-212790
Patent Document 2: US 5,714,238
Patent Document 3: JP 2013 062318
Patent Document 4: WO 2008/123362 A1

### SUMMARY OF THE INVENTION

### PROBLEM TO BE SOLVED BY THE INVENTION

In view of film thinning and improvement of magnetic properties, filling the magnetic film with soft magnetic particles at a higher proportion has been considered.

When a liquid resin composition containing the soft magnetic particles at a higher proportion is applied to a substrate and a magnetic film at a higher proportion (e.g., 60% by volume or more) is produced, however, precipitation and aggregation of the soft magnetic particles in the liquid resin composition occur and stable application cannot be achieved. As a result, there is a disadvantage that it is difficult to form (film-form) the liquid resin composition into a film shape.

Also, even when a film containing the soft magnetic particles at a higher proportion can be formed, there is a disadvantage of not being capable of obtaining excellent magnetic properties in accordance with the soft magnetic particles content. That is, there is no significant difference in magnetic properties between the magnetic film containing the higher soft magnetic particles content and the magnetic film containing the moderate soft magnetic particles content, and there is little advantage in allowing the soft magnetic particles to be contained at a higher proportion.

An object of the present invention is to provide a soft magnetic adhesive film filled with soft magnetic particles at a higher proportion and having excellent magnetic properties, a soft magnetic film laminate circuit board and a position detection device obtained from the soft magnetic adhesive film, and a soft magnetic resin composition capable of producing the soft magnetic adhesive film.

### MEANS FOR SOLVING THE PROBLEM

A soft magnetic resin composition of the present invention contains soft magnetic particles shaped flat, a resin component, and polyether phosphate ester, wherein the soft magnetic particles content is 60% by volume or more and the polyether phosphate ester content relative to 100 parts by mass of the soft magnetic particles is 0.1 to 5 parts by mass.

In the soft magnetic resin composition of the present invention, it is preferable that the polyether phosphate ester has an acid value of 10 or more.

In the soft magnetic resin composition of the present invention, it is preferable that the resin component contains acrylic resin, epoxy resin, and phenol resin.

In the soft magnetic resin composition of the present invention, it is preferable that the soft magnetic particles are Sendust.

A soft magnetic adhesive film of the present invention is formed from the above-described soft magnetic resin composition.

A soft magnetic film laminate circuit board of the present invention is obtained by laminating the above-described soft magnetic adhesive film on a circuit board.

A position detection device of the present invention includes the above-described soft magnetic film laminate circuit board.

### EFFECT OF THE INVENTION

The soft magnetic resin composition of the present invention can be stably applied in a state of containing the soft magnetic particles at a higher proportion, so that the soft magnetic adhesive film containing the soft magnetic particles at a higher proportion can be easily produced.

The soft magnetic adhesive film of the present invention is filled with the soft magnetic particles at a higher content and the soft magnetic particles are excellently oriented, so that it has excellent magnetic properties.

The soft magnetic film laminate circuit board and the position detection device of the present invention include the soft magnetic adhesive film having excellent magnetic properties, so that the performance of the position detection device is excellent and more reliable position detection is possible.

### BRIEF DESCRIPTION OF THE DRAWINGS

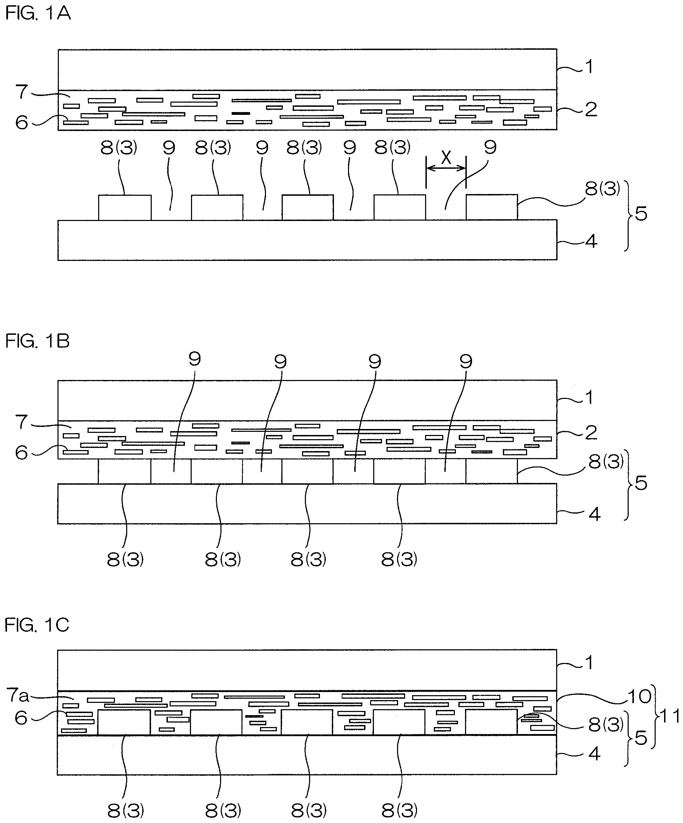

[FIG. 1] FIG. 1A shows a process drawing for illustrating one embodiment of a method for producing a soft magnetic film laminate circuit board of the present invention, illustrating a step of preparing a soft magnetic adhesive film and a circuit board;
FIG. 1B shows a process drawing for illustrating one embodiment of a method for producing a soft magnetic film laminate circuit board of the present invention, illustrating, subsequent to FIG. 1A, a step of bringing the soft magnetic adhesive film into contact with the circuit board; and
FIG. 1C shows a process drawing for illustrating one embodiment of a method for producing a soft magnetic film laminate circuit board of the present invention, illustrating, subsequent to FIG. 1B, a step of pressing the soft magnetic adhesive film to the circuit board.

### DESCRIPTION OF EMBODIMENTS

A soft magnetic resin composition of the present invention contains soft magnetic particles shaped flat (hereinafter, may be simply referred to as "soft magnetic particles"), a resin component, and polyether phosphate ester.

Examples of the soft magnetic materials of the soft magnetic particles include magnetic stainless steel (Fe-Cr-Al-Si alloy), Sendust (Fe-Si-Al alloy), permalloy (Fe-Ni alloy), silicon copper (Fe-Cu-Si alloy), Fe-Si alloy, Fe-Si-B (-Cu-Nb) alloy, Fe-Si-Cr-Ni alloy, Fe-Si-Cr alloy, Fe-Si-Al-Ni-Cr alloy, and ferrite.

Among these, preferably, Sendust (Fe-Si-Al alloy) is used. More preferably, a Fe-Si-Al alloy having a Si content of 9 to 15 mass% is used. In this manner, magnetic permeability of the soft magnetic adhesive film can be made excellent.

The soft magnetic particles are shaped flat (plate). The aspect ratio is, for example, 8 or more, preferably 15 or more, and for example, 80 or less, preferably 65 or less. The aspect ratio is calculated as an aspect ratio dividing the 50% particle size (D50) by an average thickness of the soft magnetic particles.

The soft magnetic particles have an average particle size (average length) of, for example, 3.5 µm or more, preferably 10 µm or more, and for example, 100 µm or less. The average thickness is, for example, 0.3 µm or more, preferably 0.5 µm or more, and for example, 3 µm or less, preferably 2.5 µm or less. By adjusting the aspect ratio, the average particle size, and the average thickness of the soft magnetic particles, demagnetization effects of the soft magnetic particles can be reduced, and as a result, magnetic permeability of the soft magnetic particles can be increased. To equalize the size of the soft magnetic particles, as necessary, those soft magnetic particles classified with, for example, a sieve can be used.

The soft magnetic particles content (proportion in the solid component excluding a solvent (that is, the soft magnetic particles, the resin component, and the polyether phosphate ester; and a thermosetting catalyst and an additional additive contained as necessary)) in the soft magnetic resin composition (and in the soft magnetic adhesive film and the soft magnetic film) is 60% by volume or more, preferably 65% by volume or more, and for example, 95% by volume or less, preferably 90% by volume or less and is also, for example, 80 mass% or more, preferably 85 mass% or more, and for example, 98 mass% or less, preferably 95 mass% or less. By setting the soft magnetic particles content in the range of the above-described upper limit or less, excellent film-forming properties into the soft magnetic adhesive film in the soft magnetic resin composition can be achieved. Meanwhile, by setting the soft magnetic particles content in the range of the above-described lower limit or more, the soft magnetic adhesive film having excellent magnetic properties can be achieved.

The resin component contains, for example, acrylic resin, epoxy resin, phenol resin, and the like. Preferably, the acrylic resin, the epoxy resin, and the phenol resin are used in combination. By allowing the resin component to contain these resins (thermosetting adhesive resins), the soft magnetic adhesive film (soft magnetic thermosetting adhesive film) obtained from the soft magnetic resin composition (soft magnetic thermosetting adhesive resin composition) exhibits excellent adhesiveness and excellent thermosetting properties.

An example of the acrylic resin includes an acrylic-type polymer produced by polymerizing a monomer component of one, or two or more of straight chain or branched alkyl (meth)acrylate ester having an alkyl group. "(Meth)acrylic" represents "acrylic and/or methacrylic".

An example of the alkyl group includes an alkyl group having 1 to 20 carbon atoms such as a methyl group, an ethyl group, a propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group. Preferably, an alkyl group having 1 to 6 carbon atoms is used.

The acrylic-type polymer can be a copolymer of the alkyl (meth)acrylate ester and an additional monomer.

Examples of the additional monomer include glycidyl group-containing monomers such as glycidylacrylate and glycidylmethacrylate; carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)-methylacrylate; sulfonic acid group-containing monomers such as styrenesulfonic acid, allylsulfonic acid, 2-(meth) acrylamide-2-methylpropane sulfonic acid, (meth)acrylamidepropane sulfonic acid, sulfopropyl (meth)acrylate, and (meth)acryloyloxynaphthalenesulfonic acid; phosphoric acid group-containing monomers such as 2-hydroxyethylacryloyl phosphate; styrene monomer; and acrylonitrile.

Among these, preferably, a glycidyl group-containing monomer, a carboxyl group-containing monomer, or a hydroxyl group-containing monomer is used. When the acrylic resin is a copolymer of alkyl (meth)acrylate ester and an additional monomer, that is, when the acrylic resin has a glycidyl group, a carboxyl group, or a hydroxyl group, the soft magnetic film obtained from the soft magnetic adhesive film having excellent reflow resistance can be achieved.

The mixing ratio of the additional monomer (mass) is, when a copolymer of the alkyl (meth)acrylate ester and the additional monomer is used, preferably 40 mass% or less relative to the copolymer.

The acrylic resin has a weight-average molecular weight of, for example, 1 × 10⁵ or more, preferably 3 × 10⁵ or more, and for example, 1 × 10⁶ or less. By setting the mixing ratio of the additional monomer (mass) in this range, a soft magnetic adhesive film having excellent adhesiveness and the like can be achieved. The weight-average molecular weight is measured by gel permeation chromatography (GPC) based on a polystyrene standard calibration value.

The acrylic resin has a glass transition temperature (Tg) of, for example, -30°C or more, preferably -20°C or more, and for example, 30°C or less, preferably 15°C or less. When the glass transition temperature (Tg) is the above-described lower limit or more, the soft magnetic adhesive film having excellent adhesiveness can be achieved. Meanwhile, when the glass transition temperature (Tg) is the above-described upper limit or less, the soft magnetic adhesive film having excellent handleability can be achieved. The glass transition temperature is determined based on the maximum value of the loss tangent (tanδ) measured by using a dynamic viscoelasticity measuring apparatus (DMA, frequency of 1 Hz, temperature increase rate of 10°C/min).

The acrylic resin content relative to 100 parts by mass of the resin component (e.g., a component composed of acrylic resin, epoxy resin, and phenol resin, and further additional resin (described later) blended as necessary) is, for example, 10 parts by mass or more, preferably 20 parts by mass or more, more preferably 40 parts by mass or more, and for example, 80 parts by mass or less, preferably 70 parts by mass or less. By setting the acrylic resin content in such a range, the soft magnetic resin composition having excellent film-forming properties and the soft magnetic adhesive film having excellent adhesiveness can be achieved.

The epoxy resin that is used as an adhesive composition can be, for example, used. Examples thereof include bifunctional epoxy resins and multifunctional epoxy resins such as bisphenol epoxy resin (particularly, bisphenol A epoxy resin, bisphenol F epoxy resin, bisphenol S epoxy resin, brominated bisphenol A epoxy resin, hydrogenated bisphenol A epoxy resin, bisphenol AF epoxy resin, etc.), phenol epoxy resin (particularly, phenol novolak epoxy resin, orthocresol novolak epoxy resin, etc.), biphenyl epoxy resin, naphthalene epoxy resin, fluorine epoxy resin, trishydroxyphenylmethane epoxy resin, and tetraphenylolethane epoxy resin. Furthermore, examples thereof also include hydantoin epoxy resin, trisglycidylisocyanurate epoxy resin, and glycidylamine epoxy resin. Of these epoxy resins, preferably, bisphenol epoxy resin is used, or more preferably, bisphenol A epoxy resin is used.

These can be used singly, or can be used in combination of two or more.

Containing such epoxy resins allows for excellent reactivity with the phenol resin, and as a result, the soft magnetic film having excellent reflow resistance can be achieved.

The phenol resin is a curing agent for epoxy resin, and for example, novolak-type phenol resins such as phenol novolak resin, phenol aralkyl resin, cresol novolak resin, tert-butyl phenol novolak resin, and nonylphenol novolak resin; resol-type phenol resin; and polyoxystyrene such as polyparaoxystyrene are used. These can be used singly, or can be used in combination of two or more. Of these phenol resins, preferably novolak-type resin is used, more preferably phenol novolak resin and phenol aralkyl resin are used, or further more preferably phenol aralkyl resin is used. Containing these phenol resins allows for improvement in connection reliability of the soft magnetic film laminate circuit board.

When the hydroxyl equivalent of the phenol resin relative to 100 g/eq of the epoxy equivalent of the epoxy resin is 1 g/eq or more and less than 100 g/eq, the epoxy resin content relative to 100 parts by mass of the resin component is, for example, 15 parts by mass or more, preferably 35 parts by mass or more, and for example, 70 parts by mass or less, and the phenol resin content relative to 100 parts by mass of the resin component is, for example, 5 parts by mass or more, preferably 15 parts by mass or more, and for example, 30 parts by mass or less.

When the hydroxyl equivalent of the phenol resin relative to 100 g/eq of the epoxy equivalent of the epoxy resin is 100 g/eq or more and less than 200 g/eq, the epoxy resin content relative to 100 parts by mass of the resin component is, for example, 10 parts by mass or more, preferably 25 parts by mass or more, and for example, 50 parts by mass or less, and the phenol resin content relative to 100 parts by mass of the resin component is, for example, 10 parts by mass or more, preferably 25 parts by mass or more, and for example, 50 parts by mass or less.

When the hydroxyl equivalent of the phenol resin relative to 100 g/eq of the epoxy equivalent of the epoxy resin is 200 g/eq or more and 1000 g/eq or less, the epoxy resin content relative to 100 parts by mass of the resin component is, for example, 5 parts by mass or more, preferably 15 parts by mass or more, and for example, 30 parts by mass or less, and the phenol resin content relative to 100 parts by mass of the resin component is, for example, 15 parts by mass or more, preferably 35 parts by mass or more, and for example, 70 parts by mass or less.

The epoxy equivalent when two types of epoxy resins are used in combination is an epoxy equivalent of all epoxy resins in total calculated by multiplying the epoxy equivalent of each epoxy resin by the mass ratio of each epoxy resin relative to the total amount of the epoxy resin, and adding up these.

The hydroxyl equivalent in the phenol resin per 1 equivalent of the epoxy group of the epoxy resin is, for example, 0.2 equivalent or more, preferably 0.5 equivalent or more, and for example, 2.0 equivalent or less, preferably 1.2 equivalent or less. When the amount of the hydroxyl group is in the above-described range, curing reaction of the soft magnetic adhesive film is excellent, and deterioration can be suppressed.

The resin component content of the soft magnetic resin composition is, for example, 2 mass% or more, preferably 5 mass% or more, and for example, 20 mass% or less, preferably 15 mass% or less. By setting the resin component content in the above-described range, the soft magnetic resin composition having excellent film-forming properties and the soft magnetic film having excellent magnetic properties can be achieved.

The resin component can contain an additional resin other than the acrylic resin, the epoxy resin, and the phenol resin. Such resin includes, for example, a thermoplastic resin and a thermosetting resin. These resins can be used singly, or can be used in combination of two or more.

Examples of the thermoplastic resin include natural rubber, butyl rubber, isoprene rubber, chloroprene rubber, an ethylene-vinyl acetate copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamide-imide resin, and fluorine resin.

Examples of the thermosetting resin include amino resin, unsaturated polyester resin, polyurethane resin, silicone resin, and thermosetting polyimide resin.

The additional resin content of the resin component is, for example, 10 mass% or less, preferably 5 mass% or less.

Examples of the polyether phosphate ester include polyoxyalkylene alkyl ether phosphate and polyoxyalkylene alkyl phenyl ether phosphate. Preferably, polyoxyalkylene alkyl ether phosphate is used.

The polyoxyalkylene alkyl ether phosphate has a structure in which one to three alkyl-oxy-poly(alkyleneoxy) groups are bonded to a phosphorus atom of phosphate. In the alkyl-oxy-poly(alkyleneoxy) group [that is, polyoxyalkylene alkyl ether portion], the number of repetition of alkyleneoxy related to the poly(alkyleneoxy) portion is not particularly limited, and can be appropriately selected from the range of, for example, 2 to 30 (preferably, 3 to 20). As the alkylene of the poly(alkyleneoxy) portion, preferably, an alkylene group having 2 to 4 carbon atoms is used. Specific examples thereof include an ethylene group, a propylene group, an isopropylene group, a butylene group, and an isobutyl group. The alkyl group is not particularly limited and, for example, an alkyl group having 6 to 30 carbon atoms is used, or preferably, an alkyl group having 8 to 20 carbon atoms is used. Specific examples of the alkyl group include a decyl group, an undecyl group, a dodecyl group, a tridecyl group, a tetradecyl group, a pentadecyl group, a hexadecyl group, a heptadecyl group, and an octadecyl group. When the polyoxyalkylene alkyl ether phosphate has a plurality of alkyl-oxy-poly(alkyleneoxy) groups, the plurality of alkyl groups may be different or may be the same.

These polyether phosphate esters can be used singly, or can be used in combination of two or more. The polyether phosphate ester may be a mixture with amine or the like.

To be specific, examples of the polyether phosphate ester include the HIPLAAD series manufactured by Kusumoto Chemicals, Ltd. ("ED152", "ED153", "ED154", "ED118", "ED174", and "ED251").

The polyether phosphate ester has an acid value of, for example, 10 or more, preferably 15 or more, and for example, 200 or less, preferably 150 or less. The acid value is measured by a neutralization titration method or the like.

The polyether phosphate ester content relative to 100 parts by mass of the soft magnetic particles is 0.1 parts by mass or more, preferably 0.5 parts by mass or more, and 5 parts by mass or less, preferably 2 parts by mass or less.

When the polyether phosphate ester content in the soft magnetic adhesive composition is 0.1 parts by mass or more, the polyether phosphate ester effectively functions as a dispersant and is absorbed to surfaces of the soft magnetic particles in the soft magnetic resin composition, thereby suppressing aggregation and precipitation of the soft magnetic particles. Thus, even when the soft magnetic resin composition contains the soft magnetic particles at a higher proportion, it can be stably applied and the soft magnetic adhesive film (film shape) can be surely formed.

In the obtained soft magnetic adhesive film, the soft magnetic particles shaped flat can be also uniformly oriented in a longitudinal direction (direction perpendicular to thickness direction) so as to be along a surface direction of the soft magnetic adhesive film. Particularly, usually (when the polyether phosphate ester is not contained), in the case of high soft magnetic particles shaped flat content, the apparent aspect ratio is reduced by the aggregation and precipitation of the soft magnetic particles. That is, the soft magnetic particles are brought into secondary particles (massive shape) and do not substantially function as flat shape, so that improvement in the magnetic properties cannot be expected. Meanwhile, the polyether phosphate ester content is 0.1 parts by mass or more, so that improvement in high magnetic properties in accordance with the soft magnetic particles content in the soft magnetic adhesive film at a higher proportion can be achieved. This is thought to result from the fact that the polyether phosphate ester suppresses the aggregation and precipitation of the soft magnetic particles shaped flat under a highly filled state, so that the soft magnetic particles shaped flat can be oriented as primary particles and a reduction in the magnetic properties by the aggregation and precipitation is suppressed.

The polyether phosphate ester content in the soft magnetic adhesive composition is 5 parts by mass or less, so that bleed-out of the polyether phosphate ester occurs on a surface of the soft magnetic adhesive film and a possibility of reduction in adhesive force relative to an adherend can be reduced.

When the soft magnetic resin composition contains, as a resin component, for example, the acrylic resin, the epoxy resin, and the phenol resin, preferably, a thermosetting catalyst is contained.

The thermosetting catalyst is not limited as long as the catalyst accelerates curing of the resin component by heating, and examples thereof include a salt having an imidazole skeleton, a salt having a triphenylphosphine structure, a salt having a triphenylborane structure, and an amino group-containing compound.

Examples of the salt having an imidazole skeleton include 2-phenylimidazole (trade name; 2PZ), 2-ethyl-4-methylimidazole (trade name; 2E4MZ), 2-methylimidazole (trade name; 2MZ), 2-undecylimidazole (trade name; C11Z), 2-phenyl-4,5-dihydroxymethylimidazole (trade name; 2-PHZ), and 2,4-diamino-6-[2'-methylimidazolyl (1')]-ethyl-s-triazine isocyanuric acid adduct (trade name; 2MAOK-PW) (the above-described products are all manufactured by Shikoku Chemicals Corporation).

Examples of the salt having a triphenylphosphine structure include triorganophosphine such as triphenylphosphine, tributyl phosphine, tri(p-methylphenyl) phosphine, tri(nonylphenyl) phosphine, and diphenyltolyl phosphine; tetraphenylphosphonium bromide (trade name; TPP-PB); methyltriphenylphosphonium (trade name; TPP-MB); methyltriphenylphosphonium chloride (trade name; TPP-MC); methoxymethyltriphenylphosphonium (trade name; TPP-MOC); benzyltriphenylphosphonium chloride (trade name; TPP-ZC); and methyltriphenylphosphonium (trade name; TPP-MB) (the above-described products are all manufactured by HOKKO CHEMICAL INDUSTRY CO., LTD.)

An example of the salt having a triphenylborane structure includes tri(p-methylphenyl) phosphine. The salt having a triphenylborane structure further includes those having a triphenylphosphine structure. Examples of the salt having a triphenylphosphine structure and a triphenylborane structure include tetraphenylphosphonium tetraphenylborate (trade name; TPP-K), tetraphenylphosphonium tetra-p-triborate (trade name; TPP-MK), benzyltriphenylphosphonium tetraphenylborate (trade name; TPP-ZK), and triphenylphosphine triphenylborane (trade name; TPP-S) (the above-described products are all manufactured by HOKKO CHEMICAL INDUSTRY CO., LTD.).

Examples of the amino group-containing compound include monoethanolaminetrifluoroborate (manufactured by STELLACHEMIFA CORPORATION) and dicyandiamide (manufactured by NACALAI TESQUE, INC.).

The thermosetting catalyst has a shape of, for example, spherical or ellipsoidal.

These thermosetting catalysts can be used singly, or can be used in combination of two or more.

The mixing ratio of the thermosetting catalyst relative to 100 parts by mass of the resin component is, for example, 0.2 parts by mass or more, preferably 0.3 parts by mass or more, and for example, 5 parts by mass or less, preferably 2 parts by mass or less. When the mixing ratio of the thermosetting catalyst is the above-described upper limit or less, storage stability for a long period of time at room temperature of the soft magnetic adhesive film (soft magnetic thermosetting adhesive film) can be made excellent. Meanwhile, when the mixing ratio of the thermosetting catalyst is the above-described lower limit or more, the soft magnetic adhesive film can be cured by heating at low temperature and for a short period of time, and reflow resistance of the soft magnetic film can be made excellent.

The soft magnetic resin composition may further contain an additional additive as necessary. Examples of the additive include commercially available or known additives such as a cross-linking agent and an inorganic filler.

Examples of the cross-linking agent include polyisocyanate compounds such as tolylene diisocyanate, diphenylmethane diisocyanate, p-phenylenediisocyanate, 1,5-naphthalenediisocyanate, and an adduct of polyhydric alcohol and diisocyanate.

The cross-linking agent content relative to 100 parts by mass of the resin component is, for example, 7 parts by mass or less and more than 0 part by mass.

Furthermore, an inorganic filler can be suitably blended in the soft magnetic resin composition in accordance with its use. Thermal conductivity and modulus of elasticity of the soft magnetic film can be improved in this manner.

Examples of the inorganic filler include ceramics such as silica, clay, gypsum, calcium carbonate, barium sulfate, alumina oxide, beryllium oxide, silicon carbide, and silicon nitride; metals or alloys of aluminum, copper, silver, gold, nickel, chromium, lead, tin, zinc, palladium, and solder; and also carbon. These inorganic fillers can be used singly, or can be used in combination of two or more.

The inorganic filler has an average particle size of, for example, 0.1 µm or more and 80 µm or less.

When the inorganic filler is blended, its mixing ratio relative to 100 parts by mass of the resin component is, for example, 80 parts by mass or less, preferably 70 parts by mass or less, and for example, more than 0 part by mass.

Next, description is given below of a method for producing a soft magnetic adhesive film of the present invention.

To produce the soft magnetic adhesive film, first, a soft magnetic resin composition is obtained by mixing the above-described components and next, the soft magnetic resin composition is dissolved or dispersed in a solvent, so that a soft magnetic resin composition solution is prepared.

Examples of the solvent include organic solvents such as ketones including acetone and methyl ethyl ketone (MEK); esters such as ethyl acetate; amides such as N,N-dimethylformamide; and ethers such as propylene glycol monomethyl ether. Examples of the solvent also include water-based solvents such as water and alcohols such as methanol, ethanol, propanol, and isopropanol.

The soft magnetic resin composition solution has a solid content of, for example, 10 mass% or more, preferably 30 mass% or more, more preferably 40 mass% or more, and for example, 90 mass% or less, preferably 70 mass% or less, more preferably 50 mass% or less.

The polyether phosphate ester in a state of being blended in the solvent in advance can be also mixed with the above-described components. After mixture, a solvent is further added to the soft magnetic resin composition, so that the soft magnetic resin composition solution may be prepared.

Then, the soft magnetic resin composition solution is applied to a surface of a substrate (separator, core material, etc.) to give a predetermined thickness to form a coating, and then, the coating is dried under predetermined conditions. A soft magnetic adhesive film is produced in this manner.

The application method is not particularly limited and, for example, doctor blades, roll coating, screen coating, and gravure coating can be used.

Examples of drying conditions include a drying temperature of, for example, 70°C or more and 160°C or less, and a drying time of, for example, 1 minute or more and 5 minutes or less.

The soft magnetic adhesive film has an average film thickness of, for example, 5 µm or more, preferably 50 µm or more, and for example, 1000 µm or less, preferably 500 µm or less, more preferably 300 µm or less.

The soft magnetic adhesive film is in a semi-cured state (B-stage state) under room temperature (to be specific, at 25°C).

The soft magnetic adhesive film has an average thickness of, for example, 5 µm or more, preferably 50 µm or more, and for example, 500 µm or less, preferably 250 µm or less.

Examples of the separator include a polyethylene terephthalate (PET) film, a polyethylene film, a polypropylene film, and paper. The surfaces of these examples of the separator are subjected to release treatment with, for example, a fluorine release agent, a long-chain alkylacrylate release agent, and a silicone release agent.

Examples of the core material include a plastic film (e.g., polyimide film, polyester film, polyethylene terephthalate film, polyethylene naphthalate film, polycarbonate film, etc.); a metal film (e.g., aluminum foil etc.); and a resin substrate, a silicon substrate, and a glass substrate reinforced with, for example, glass fiber and plastic nonwoven fiber.

The separator or the core material has an average thickness of, for example, 1 µm or more and 500 µm or less.

The soft magnetic adhesive film of the present invention can be a single-layer structure of, for example, only a soft magnetic adhesive film, a multi-layer structure in which a soft magnetic adhesive film is laminated on one side or both sides of the core material, and a multi-layer structure in which a separator is laminated on one side or both sides of the soft magnetic curable adhesive film.

A preferred embodiment of the present invention is a multi-layer structure in which a separator is laminated on one side or both sides of the soft magnetic adhesive film. In this manner, the soft magnetic adhesive film can be protected until practical use, and furthermore, can be used as a support substrate at the time of transferring the soft magnetic adhesive film to the circuit board.

Next, description is given below of an embodiment of a method (bonding method of the soft magnetic adhesive film) for producing a soft magnetic film laminate circuit board with reference to FIGS. 1A to 1C.

In this method, first, as shown in FIG. 1A, a soft magnetic adhesive film 2 on which a separator 1 is laminated and a circuit board 5 in which a wire pattern 3 is formed on a surface of a substrate 4 are prepared and then, the soft magnetic adhesive film 2 and the circuit board 5 are disposed to face each other in spaced-apart relation in the thickness direction.

The soft magnetic adhesive film 2 can be produced in the above-described method, and soft magnetic particles (soft magnetic particles shaped flat) 6 are dispersed in the soft magnetic resin composition (in the embodiment in FIG. 1A, a resin component 7 composed of acrylic resin, epoxy resin, and phenol resin and polyether phosphate ester (not shown)). In the embodiment shown in FIG. 1A, the soft magnetic particles 6 are oriented such that their longitudinal direction (direction perpendicular to the thickness direction) is along the surface direction of the soft magnetic adhesive film 2.

The circuit board 5 is, for example, a circuit board 5 used with electromagnetic induction method, and on one side of the substrate 4, the wire pattern 3 such as loop coil is formed. The wire pattern 3 is formed by, for example, a semi-additive method or a subtractive method.

Examples of the insulating material that forms the substrate 4 include a glass epoxy substrate, a glass substrate, a PET substrate, a Teflon substrate, a ceramics substrate, and a polyimide substrate.

The wire pattern 3 is, for example, formed of a conductor such as copper.

A wire 8 that forms the wire pattern 3 has a width of, for example, 5 µm or more, preferably 9 µm or more, and for example, 500 µm or less, preferably 300 µm or less.

The wire 8 has a thickness (height) of, for example, 5 µm or more, preferably 10 µm or more, and for example, 50 µm or less, preferably 35 µm or less.

Gaps 9 (pitches, length of X shown in FIG. 1A) between the wires 8 are, for example, 50 µm or more, preferably 80 µm or more, and for example, 3 mm or less, preferably 2 mm or less.

Then, as shown in FIG. 1B, the soft magnetic adhesive film 2 is brought into contact with the upper surfaces of the wires 8.

Thereafter, as shown in FIG. 1C, the soft magnetic adhesive film 2 is pressed against the wires 8, while being heated under vacuum. In this manner, the soft magnetic resin composition forming the soft magnetic adhesive film 2 flows and the wire pattern 3 is embedded in the soft magnetic resin composition, while a void in the soft magnetic adhesive film 2 is reduced and high density thereof is achieved. That is, the front surfaces and the side surfaces of the wires 8 that form the wire pattern 3 are covered with the soft magnetic resin composition. Together with the coverage of the front surfaces and the side surfaces of the wires 8, the front surface of the substrate 4 exposed from the wire pattern 3 is covered with the soft magnetic resin composition. Also, the resin component cures by heating.

The pressure is, for example, 10 kN/cm² or more, preferably 100 kN/cm² or more, and for example, 1000 kN/cm² or less, preferably 500 kN/cm² or less.

The heating temperature is, for example, 80°C or more, preferably 100°C or more, and for example, 200°C or less, preferably 175°C or less.

The heating time is, for example, 0.1 hours or more, preferably, 0.2 hours or more, and for example, 24 hours or less, preferably 3 hours or less, more preferably 2 hours or less.

The degree of vacuum is, for example, 2000 Pa or less, preferably 1000 Pa or less, more preferably 100 Pa or less.

In this manner, as shown in FIG. 1C, a soft magnetic film laminate circuit board 11 in which a soft magnetic film 10 is laminated on the circuit board 5 is produced.

The soft magnetic film laminate circuit board 11 thus produced includes the circuit board 5 formed with the wire pattern 3 and the soft magnetic film 10 on which the circuit board 5 is laminated.

The soft magnetic film 10 is formed from the soft magnetic particles 6, a cured resin component 7a that is cured by heating, and polyether phosphate ester, and is in a cured state (C-stage state).

In the obtained soft magnetic film 10, the soft magnetic particles 6 content relative to the soft magnetic film 10 is 60% by volume or more, preferably 65% by volume or more, and for example, 95% by volume or less, preferably 90% by volume or less.

In the soft magnetic film laminate circuit board 11, the wire pattern 3 is embedded in the soft magnetic film 10. That is, the front surfaces and the side surfaces of the wires 8 that form the wire pattern 3 are covered with the soft magnetic film 10. Together with the coverage of the front surfaces and the side surfaces of the wires 8, the front surface of the substrate 4 exposed from the wire pattern 3 is covered with the soft magnetic film 10.

Between the separator 1 and the wires 8 or the substrate 4, and in the gaps 9 between the wires 8, the soft magnetic particles 6, the cured resin component 7a, and the polyether phosphate ester are present, and the soft magnetic particles 6 are oriented without aggregation such that their longitudinal direction (direction perpendicular to the thickness direction) is along the surface direction of the soft magnetic film 10.

In the embodiments of FIGS. 1A to 1C, the circuit board 5 having the wire pattern 3 formed on only one side is used. However, the circuit board 5 having the wire patterns 3 on both on one side and the other side can be also used.

In the embodiments of FIGS. 1A to 1C, only one (one layer) of the soft magnetic adhesive film 2 is bonded onto the circuit board. However, the soft magnetic adhesive film 2 can be also bonded in a plural number (a plurality of layers) to produce the soft magnetic film 10 having a desired thickness. In such a case, for example, 2 to 20 layers are bonded, or preferably 2 to 5 layers are bonded.

In the embodiments of FIGS. 1A to 1C, the soft magnetic adhesive film 2 in the B-stage state is directly laminated on (bonded to) the circuit board 5. Alternatively, for example, the soft magnetic adhesive film 2 in the B-stage state is cured by heating in advance, thereby producing the soft magnetic film 10 in a C-stage state. Next, the produced soft magnetic film 10 can be also laminated on the circuit board 5 via an adhesive layer.

The conditions (heating time, heating temperature) for curing by heating are the same as those described above.

As the adhesive layer, a known adhesive layer usually used as an adhesive layer of a circuit board is used. The adhesive layer is, for example, formed by applying adhesives such as an epoxy adhesive, a polyimide adhesive, and an acrylic adhesive to be dried. The adhesive layer has a thickness of, for example, 10 to 100 µm.

A position detection device of the present invention includes, for example, a sensor board having the above-described soft magnetic film laminate circuit board 11 and a sensor portion mounted on the soft magnetic film laminate circuit board, and a position detection flat plate disposed above and to face the sensor board.

Examples of the reflowing process at the time of mounting the sensor portion on the soft magnetic film laminate circuit board 11 include, for example, hot air reflowing and infrared reflowing. The heating can be either entirely or partially.

The heating temperature in the reflowing step is, for example, 200°C or more, preferably 240°C or more, and for example, 300°C or less, preferably 265°C or less. The heating time is, for example, 1 second or more, preferably 5 seconds or more, more preferably 30 seconds or more, and for example, 2 minutes or less, preferably 1.5 minutes or less.

The position detection device is produced by disposing the position detection flat plate to face the above-described sensor board in spaced-apart relation.

Then, the soft magnetic resin composition contains the soft magnetic particles shaped flat 6, the resin component 7, and the polyether phosphate ester; the soft magnetic particles content is 60% by volume or more; and the polyether phosphate ester content relative to 100 parts by mass of the soft magnetic particles is 0.1 to 5 parts by mass.

Thus, the soft magnetic resin composition can be stably applied in a state of containing the soft magnetic particles 6 at a higher proportion. As a result, the soft magnetic adhesive film 2 containing the soft magnetic particles 6 at a higher proportion can be easily produced. Also, the soft magnetic particles shaped flat 6 in the soft magnetic adhesive film 2 can be oriented even in a state of being contained at a higher proportion. Thus, the produced soft magnetic adhesive film 2 having excellent magnetic properties can be achieved.

Also, the soft magnetic adhesive film 2 is formed from the soft magnetic resin composition containing the soft magnetic particles shaped flat 6, the resin component 7, and the polyether phosphate ester and in which the soft magnetic particles 6 content is 60% by volume or more and the polyether phosphate ester content relative to 100 parts by mass of the soft magnetic particles is 0.1 to 5 parts by mass.

Thus, the soft magnetic adhesive film 2 contains the soft magnetic particles shaped flat 6 at a higher proportion and the soft magnetic particles shaped flat 6 are oriented in the longitudinal direction without aggregation. Thus, the soft magnetic adhesive film 2 has high magnetic properties in accordance with the soft magnetic particles content.

The soft magnetic film laminate circuit board 11 and the position detection device are produced by using the soft magnetic adhesive film 2 having excellent magnetic properties, so that the performance of the position detection device is excellent and more reliable position detection is possible.

### Examples

While in the following, the present invention is described in further detail with reference to Examples and Comparative Examples, the present invention is not limited to any of them by no means. The numeral values in Examples shown below can be replaced with the numeral values shown in the above-described embodiments (that is, the upper limit value or the lower limit value).

### Example 1

### (Preparation of Soft Magnetic Resin Composition)

A soft magnetic resin composition (soft magnetic thermosetting resin composition) was produced by mixing 500 parts by mass of soft magnetic particles (Fe-Si-Al alloy, flat, manufactured by Mate Co., Ltd.), 2.5 parts by mass (0.5 parts by mass relative to 100 parts by mass of the soft magnetic particles) of polyether phosphate ester (manufactured by Kusumoto Chemicals, Ltd., "ED152", acid value of 17), 25 parts by mass of an acrylate ester polymer mainly composed of ethyl acrylate-methyl methacrylate (manufactured by Negami Chemical Industirial Co., Ltd., trade name "Paracron W-197CM"), 13 parts by mass of bisphenol A epoxy resin (manufactured by JER, Epikote 1004), 7 parts by mass of bisphenol A epoxy resin (manufactured by JER, Epikote YL980), 9 parts by mass of phenol aralkyl resin (manufactured by Mitsui Chemicals, Inc., Milex XLC-4L), and 0.54 parts by mass (1.0 part by mass relative to 100 parts by mass of the resin component) of 2,4-diamino-6-[2'-methylimidazolyl-(1')]-ethyl-s-triazine isocyanuric acid adduct (thermosetting catalyst, manufactured by Shikoku Chemicals Corporation, "2MAOK-PW") so that the soft magnetic particles were 60% by volume relative to the soft magnetic resin composition.

### (Production of Soft Magnetic Adhesive Film)

The soft magnetic resin composition was dissolved in methyl ethyl ketone, thereby producing a soft magnetic resin composition solution having a solid content concentration of 43 mass%.

The soft magnetic resin composition solution was applied on a separator (average thickness of 50 µm) composed of a polyethylene terephthalate film subjected to silicone release treatment with an applicator, and thereafter, dried at 130°C for 2 minutes.

In this manner, a soft magnetic adhesive film (soft magnetic thermosetting adhesive film) on which the separator was laminated was produced. The soft magnetic adhesive film had an average thickness of 90 µm. The soft magnetic adhesive film was in a semi-cured state. When a surface state of the soft magnetic adhesive film was observed by SEM, soft magnetic particles shaped flat did not cause unevenness by aggregation and the longitudinal direction thereof was oriented along the surface direction of the soft magnetic adhesive film.

### Example 2

### (Preparation of Soft Magnetic Resin Composition)

A soft magnetic resin composition was produced by mixing 500 parts by mass of soft magnetic particles (same as described above), 5 parts by mass (1.0 part by mass relative to 100 parts by mass of the soft magnetic particles) of polyether phosphate ester (manufactured by Kusumoto Chemicals, Ltd., "ED153", acid value of 55, content amount of 50 mass%, solvent: propylene glycol monomethyl ether), 20 parts by mass of an acrylate ester polymer mainly composed of ethyl acrylate-methyl methacrylate (same as described above), 10 parts by mass of bisphenol A epoxy resin (manufactured by JER, Epikote 1004), 6 parts by mass of bisphenol A epoxy resin (manufactured by JER, Epikote YL980), 7 parts by mass of phenol aralkyl resin (same as described above), and 0.43 parts by mass (1.0 part by mass relative to 100 parts by mass of the resin component) of 2,4-diamino-6-[2'-methylimidazolyl-(1')]-ethyl-s-triazine isocyanuric acid adduct (thermosetting catalyst, manufactured by Shikoku Chemicals Corporation, "2MAOK-PW") so that the soft magnetic particles were 65% by volume.

### (Production of Soft Magnetic Adhesive Film)

The soft magnetic resin composition was dissolved in methyl ethyl ketone, thereby producing a soft magnetic resin composition solution having a solid content concentration of 43 mass%.

Next, a soft magnetic adhesive film on which a separator was laminated was produced in the same manner as in Example 1. The soft magnetic adhesive film was in a semi-cured state. When a surface state of the soft magnetic adhesive film was observed by SEM, soft magnetic particles shaped flat did not cause unevenness by aggregation and the longitudinal direction thereof was oriented along the surface direction of the soft magnetic adhesive film.

### Example 3

### (Preparation of Soft Magnetic Resin Composition)

A soft magnetic resin composition was produced by mixing 500 parts by mass of soft magnetic particles (same as described above), 25 parts by mass (5.0 parts by mass relative to 100 parts by mass of the soft magnetic particles) of polyether phosphate ester (manufactured by Kusumoto Chemicals, Ltd., "ED154", acid value of 114), 16 parts by mass of an acrylate ester polymer mainly composed of ethyl acrylate-methyl methacrylate (same as described above), 6 parts by mass of bisphenol A epoxy resin (manufactured by JER, Epikote 1004), 8 parts by mass of bisphenol A epoxy resin (manufactured by JER, Epikote YL980), 5 parts by mass of phenol aralkyl resin (same as described above), and 0.35 parts by mass (1.0 part by mass relative to 100 parts by mass of the resin component) of 2,4-diamino-6-[2'-methylimidazolyl-(1')]-ethyl-s-triazine isocyanuric acid adduct (thermosetting catalyst, manufactured by Shikoku Chemicals Corporation, "2MAOK-PW") so that the soft magnetic particles were 70% by volume.

### (Production of Soft Magnetic Adhesive Film)

The soft magnetic resin composition was dissolved in methyl ethyl ketone, thereby producing a soft magnetic resin composition solution having a solid content concentration of 43 mass%.

Next, a soft magnetic adhesive film on which a separator was laminated was produced in the same manner as in Example 1. The soft magnetic adhesive film was in a semi-cured state. When a surface state of the soft magnetic adhesive film was observed by SEM, soft magnetic particles shaped flat did not cause unevenness by aggregation and the longitudinal direction thereof was oriented along the surface direction of the soft magnetic adhesive film.

### Comparative Example 1

A soft magnetic resin composition was obtained in the same manner as in Example 1, except that the polyether phosphate ester was not contained.

Next, a soft magnetic adhesive film was produced in the same manner as in Example 1, except that the obtained soft magnetic resin composition was used.

### Comparative Example 2

A soft magnetic resin composition was obtained in the same manner as in Example 2, except that the polyether phosphate ester was not contained.

Next, a soft magnetic adhesive film was produced in the same manner as in Example 1, except that the obtained soft magnetic resin composition was used.

### Comparative Example 3

A soft magnetic resin composition was obtained in the same manner as in Example 3, except that the polyether phosphate ester was not contained.

Next, a soft magnetic adhesive film was produced in the same manner as in Example 1, except that the obtained soft magnetic resin composition was used.

### Comparative Example 4

A soft magnetic resin composition was obtained in the same manner as in Example 2, except that 3-methacryloxypropyltrimethoxysilane (manufactured by Shin-Etsu Chemical Co., Ltd., silane coupling agent, "KBM503") was contained instead of the polyether phosphate ester.

Next, a soft magnetic adhesive film was produced in the same manner as in Example 1, except that the obtained soft magnetic resin composition was used.

### Comparative Example 5

A soft magnetic resin composition was obtained in the same manner as in Example 3, except that 2-(3,4-epoxycyclohexyl)ethyltrimethoxysilane (manufactured by Shin-Etsu Chemical Co., Ltd., silane coupling agent, "KBM303") was contained instead of the polyether phosphate ester.

Next, a soft magnetic adhesive film was produced in the same manner as in Example 1, except that the obtained soft magnetic resin composition was used.

### Comparative Example 6

A soft magnetic resin composition was obtained in the same manner as in Example 1, except that 500 parts by mass of soft magnetic particles (same as described above) and 2.5 parts by mass (0.5 parts by mass relative to 100 parts by mass of the soft magnetic particles) of polyether phosphate ester (manufactured by Kusumoto Chemicals, Ltd., "ED152", acid value of 17) were blended so that the soft magnetic particles were 50% by volume to obtain the mixing proportion described in Table 1.

Next, a soft magnetic adhesive film was produced in the same manner as in Example 1, except that the obtained soft magnetic resin composition was used.

### Comparative Example 7

A soft magnetic resin composition was obtained in the same manner as in Comparative Example 6, except that the polyether phosphate ester was not contained.

Next, a soft magnetic adhesive film was produced in the same manner as in Example 1, except that the obtained soft magnetic resin composition was used.

### (Evaluation)

### •Forming Properties (Film-Forming Properties)

At the time of producing the soft magnetic adhesive films of Examples and Comparative Examples, those soft magnetic resin composition solutions stably applied on a separator and no roughness occurring on the surfaces of the produced soft magnetic adhesive films were evaluated as Good; those soft magnetic resin composition solutions stably applied on a separator but roughness confirmed on the surfaces of the produced soft magnetic adhesive films were evaluated as Poor; and those soft magnetic resin composition solutions not stably applied and failing to form a film shape were2 evaluated as Bad.

The results are shown in Table 1.

### •Magnetic Properties

### (Production of Soft Magnetic Film Laminate Circuit Board)

Double-sided wire pattern forming circuit boards (total thickness of 48 µm, width of wire of 100 µm, gap (pitch) between wires of 500 µm) in which a loop coil wire pattern having a thickness of 15 µm was formed on both sides of a board having flexibility (polyimide film, thickness of 18 µm) were prepared.

The soft magnetic adhesive films of Examples and Comparative Examples were laminated so that the surfaces of the soft magnetic thermosetting films were in contact with one side (wire pattern surface) of the circuit boards to be next disposed in a vacuum hot pressing device (manufactured by Mikado Technos Co., Ltd.).

Next, hot pressing was performed under the conditions of a vacuum of 1000 Pa, a temperature of 175°C, and a pressure of 400 kN/cm² for 30 minutes, so that the soft magnetic thermosetting films were thermally cured. In this manner, soft magnetic film laminate circuit boards were produced.

In the soft magnetic film of each of the obtained soft magnetic film laminate circuit boards, the magnetic permeability µ' thereof at a frequency of 1 MHz was measured by a one turn method by using an impedance analyzer (manufactured by Agilent Technologies, product number "4294A").

The results are shown in Table 1.

**[Table 1]**

| [Table 1] | | | | | | | | | | | | | |
|---|---|---|---|---|---|---|---|---|---|---|---|---|---|
| | | | | Ex. 1 | Ex. 2 | Ex. 3 | Comp. Ex. 1 | Comp. Ex. 2 | Comp. Ex. 3 | Comp. Ex. 4 | Comp. Ex. 5 | Comp. Ex. 6 | Comp. Ex. 7 |
| Soft Magnetic Resin Composition | Soft Magnetic Particles | Fe-Si-Al | parts by mass | 500 | 500 | 500 | 500 | 500 | 500 | 500 | 500 | 500 | 500 |
| | | | (parts by volume) | (60) | (65) | (70) | (60) | (65) | (70) | (65) | (70) | (50) | (50) |
| | Polyether Phosphate Ester | ED152 | | 2.5 | - | - | - | - | - | - | - | 2.5 | - |
| | | ED153 | | - | 5 | - | - | - | - | - | - | - | - |
| | | ED154 | | - | - | 25 | - | - | - | - | - | - | - |
| | | (number of parts by mass relative to 100 parts by mass of soft magnetic particles) | | (0.5) | (1.0) | (5.0) | - | - | - | - | - | (0.5) | - |
| | Silane Coupling Agent | KBM503 | | - | - | - | - | - | - | 5 | - | - | - |
| | | KBM303 | | - | - | - | - | - | - | - | 25 | - | - |
| | | (number of parts by mass relative to 100 parts by mass of soft magnetic particles) | | - | - | - | - | - | - | (1.0) | 5.0 | - | - |
| | Resin Component | Acrylic Resin | Paracron W-197CM | 25 | 20 | 16 | 25 | 20 | 16 | 20 | 16 | 37 | 37 |
| | | Epoxy Resin | Epikote 1004 | 13 | 10 | 6 | 13 | 10 | 6 | 10 | 6 | 19 | 19 |
| | | | Epikote YL980 | 7 | 6 | 8 | 7 | 6 | 8 | 6 | 8 | 11 | 11 |
| | | Phenol Resin | MILEX XLC-4L | 9 | 7 | 5 | 9 | 7 | 5 | 7 | 5 | 13 | 13 |
| | Thermosetting Catalyst | 2MAOK-PW | | 0.54 | 0.43 | 0.35 | 0.54 | 0.43 | 0.35 | 0.43 | 0.35 | 0.80 | 0.80 |
| | | (number of parts by mass relative to 100 parts by mass of resin component) | | (1.0) | (1.0) | (1.0) | (1.0) | (1.0) | (1.0) | (1.0) | (1.0) | (1.0) | (1.0) |
| Evaluation | Film-Forming Properties | | | Good | Good | Good | Poor | Poor | Poor | Poor | Poor | Poor | Poor |
| | Magnetic Permeability µ' | | | 180 | 200 | 220 | 140 | 145 | 150 | 145 | 150 | 140 | 140 |

The numeral values for the components in Table represent parts by mass unless otherwise noted.

Details of the components shown in Table are shown below.
- Fe-Si-Al alloy: trade name "SP-7", soft magnetic particles, average particle size of 65 µm, flat, manufactured by Mate Co., Ltd.
- Paracron W-197CM: trade name, acrylate ester polymer mainly composed of ethyl acrylate-methyl methacrylate, manufactured by Negami Chemical Industrial Co., Ltd.
- Epikote 1004: trade name, bisphenol A epoxy resin, epoxy equivalent of 875 to 975 g/eq, manufactured by JER
- Epikote YL980: trade name, bisphenol A epoxy resin, epoxy equivalent of 180 to 190 g/eq, manufactured by JER
- MILEX XLC-4L: trade name, phenolaralkyl resin, hydroxyl equivalent of 170 g/eq, manufactured by Mitsui Chemicals, Inc.
- ED152: trade name "HIPLAAD ED152", polyether phosphate ester, manufactured by Kusumoto Chemicals, Ltd., acid value of 17
- ED153: trade name "HIPLAAD ED153", polyether phosphate ester, manufactured by Kusumoto Chemicals, Ltd., acid value of 55, content amount of 50 mass%, solvent: propylene glycol monomethyl ether
- ED154: trade name "HIPLAAD ED154", polyether phosphate ester, manufactured by Kusumoto Chemicals, Ltd., acid value of 114
- KBM503: trade name, 3-methacryloxypropyltrimethoxysilane, manufactured by Shin-Etsu Chemical Co., Ltd., silane coupling agent
- KBM303: trade name, 2-(3,4-epoxycyclohexyl)ethyltrimethoxysilane, manufactured by Shin-Etsu Chemical Co., Ltd., silane coupling agent
- 2MAOK-PW: trade name, 2,4-diamino-6-[2'-methylimidazolyl-(1')]-ethyl-s-triazine isocyanuric acid adduct, manufactured by Shikoku Chemicals Corporation

### (Consideration)

As clear from Table 1, when the soft magnetic resin compositions containing the polyether phosphate ester of Examples are used, more excellent forming properties (film-forming properties) can be developed than the soft magnetic resin composition without containing the polyether phosphate ester (Comparative Example 1), and the soft magnetic adhesive films and the soft magnetic films having more excellent magnetic properties can be obtained.

The soft magnetic resin compositions of Examples develop excellent forming properties (film-forming properties) relative to the soft magnetic resin compositions (Comparative Examples 4 and 5) containing the silane coupling agent and aiming at improvement in dispersibility by subjecting the soft magnetic particles to surface treatment, and the soft magnetic adhesive films and the soft magnetic films having more excellent magnetic properties can be obtained.

### Industrial Applicability

The soft magnetic resin composition, the soft magnetic adhesive film, the soft magnetic film laminate circuit board, and the position detection device of the present invention can be applied in various industrial products. For example, the soft magnetic resin composition, the soft magnetic adhesive film, and the soft magnetic film laminate circuit board of the present invention can be used for a position detection device or the like, and the position detection device of the present invention can be used for input devices for computers such as digitizers.

### Description of Reference Numerals

- 2: Soft magnetic adhesive film
- 5: Circuit board
- 6: Soft magnetic particles
- 7: Resin component
- 10: Soft magnetic film
- 11: Soft magnetic film laminate circuit board

## Claims

1. A soft magnetic resin composition comprising:
60% by volume or more of soft magnetic particles shaped flat, a resin component, and **characterised by** further comprising polyether phosphate ester,
wherein the polyether phosphate ester content relative to 100 parts by mass of the soft magnetic particles is 0.1 to 5 parts by mass

2. The soft magnetic resin composition according to claim 1, wherein
the polyether phosphate ester has an acid value of 10 or more.

3. The soft magnetic resin composition according to claim 1, wherein
the resin component contains acrylic resin, epoxy resin, and phenol resin.

4. The soft magnetic resin composition according to claim 1, wherein
the soft magnetic particles are Sendust.

5. A soft magnetic adhesive film formed from a soft magnetic resin composition according to claim 1.

6. A soft magnetic film laminate circuit board obtained by laminating a soft magnetic adhesive film according to claim 5 on a circuit board.

7. A position detection device comprising a soft magnetic film laminate circuit board according to claim 6.

## Patentansprüche

1. Weichmagnetische Harzzusammensetzung, die 60 Vol.-% oder mehr an flach geformten weichmagnetischen Teilchen und eine Harzkomponente umfasst, und die **dadurch gekennzeichnet ist, dass** sie ferner einen Polyetherphosphatester umfasst,
wobei der Gehalt an Polyetherphosphatester, bezogen auf 100 Massenteile der weichmagnetischen Teilchen, 0,1 bis 5 Massenteile beträgt.

2. Weichmagnetische Harzzusammensetzung gemäß Anspruch 1, wobei der Polyetherphosphatester eine Säurezahl von 10 oder mehr aufweist.

3. Weichmagnetische Harzzusammensetzung gemäß Anspruch 1, wobei die Harzkomponente Acrylharz, Epoxidharz und Phenolharz enthält.

4. Weichmagnetische Harzzusammensetzung gemäß Anspruch 1, wobei die weichmagnetischen Teilchen Sendust sind.

5. Weichmagnetische Klebefolie, gebildet aus einer weichmagnetischen Harzzusammensetzung gemäß Anspruch 1.

6. Leiterplatte mit darauf laminierter weichmagnetischer Folie, erhalten durch Laminieren einer weichmagnetischen Klebefolie gemäß Anspruch 5 auf eine Leiterplatte.

7. Positionsbestimmungsvorrichtung, umfassend eine Leiterplatte mit darauf laminierter weichmagnetischer Folie gemäß Anspruch 6.

## Revendications

1. Composition de résine à aimantation temporaire comprenant :
60% en volume ou plus de particules aplaties à aimantation temporaire, un composant de résine et **caractérisée en ce qu'**elle comprend en outre un ester de phosphate-polyéther, dans laquelle
la teneur en ester de phosphate-polyéther par rapport à 100 parties en masse des particules à aimantation temporaire est de 0,1 à 5 parties en masse.

2. Composition de résine à aimantation temporaire selon la revendication 1, dans laquelle
l'ester de phosphate-polyéther présente une valeur acide de 10 ou plus.

3. Composition de résine à aimantation temporaire selon la revendication 1, dans laquelle
le composant de résine contient une résine acrylique, une résine époxy et une résine phénolique.

4. Composition de résine à aimantation temporaire selon la revendication 1, dans laquelle
les particules à aimantation temporaire sont de la sendust.

5. Film adhésif à aimantation temporaire formé à partir d'une composition de résine à aimantation temporaire selon la revendication 1.

6. Carte de circuit à film à aimantation temporaire stratifié obtenue en stratifiant un film adhésif à aimantation temporaire selon la revendication 5 sur une carte de circuit.

7. Dispositif de détection de position comprenant une carte de circuit à film à aimantation temporaire stratifié selon la revendication 6.
